# EUROPEAN PATENT APPLICATION

(11) **EP 0 901 163 A2**
(43) Date of publication of application: **10.03.1999**
(21) Application number: 98307190.3
(22) Date of filing: 07.09.1998
(51) Int. Cl.: H01L 21/77, G02F 1/136

(54) **Semiconductor device having laser-annealed semiconductor elements, and display device using this semiconductor device**

(30) Priority: 08.09.1997 JP 243054/97
(71) Applicant: SANYO ELECTRIC CO., LIMITED., Moriguchi City, Osaka (JP)
(72) Inventor: Yoneda, Kiyoshi, Motosu-gun, Gifu-ken (JP); Kihara, Katsuya, Kobe-shi, Hyogo-ken (JP)
(74) Representative: Cross, Rupert Edward Blount

(57) **Abstract**

In a driver built-in type p-Si TFT LCD, a channel width direction of a sampling TFT (6) constituting a part of a driver and having a large channel width is formed in a direction non-parallel with sides of a substrate or sides of pulse laser beams radiated for poly-crystallization of a-Si. For example, the channel width direction of the sampling TFT (6) is formed to have an angle of 45° relative to the substrate sides. Therefore, even when a dispersion in energy intensity is generated in an irradiated plane of pulse laser beams radiated to a-Si in a poly-crystallization process and a defective crystallized region [R] is formed on a p-Si film (13) in a direction corresponding to the dispersion, the defective crystallized region [R] extends across a part of each TFT (6). Formation of only a specified TFT (6) in the defective crystallized region [R] and occurrence of a difference in characteristics between the specified TFT and another TFT (6) are prevented. Consequently, generation of a low display-quality portion on a specified column on LCD and deterioration of display quality of the entire LCD are prevented.

## Description

### BACKGROUND OF THE INVENTION

### 1.Field of the Invention

The present invention relates to a semiconductor device, especially a liquid crystal display (LCD), and a method of manufacturing an integrated drive-circuit type LCD in which a plurality of thin-film transistors (TFT) are formed in a display area and a peripheral area.

### 2.Description of the Related Art

Recently, LCDs have been put to practical use in the fields of OA equipment, AV equipment and the like because of their small and thin configuration, low power consumption and other advantages. Especially, since an active matrix type LCD, in which a TFT is disposed as a switching element for controlling a timing for rewriting image data in each pixel, can display high-resolution animation in a large image plane, it is used in displays of various televisions, personal computers, and the like.

A TFT is a field effect transistor (FET) which is obtained by forming a semiconductor layer together with a metal layer in a predetermined configuration on an insulating substrate. In the active matrix type LCD, a TFT is connected to one electrode of each capacitor formed between a pair of substrates between which a liquid crystal is held, and the liquid crystal is operated by each capacitor.

Particularly, an LCD has been developed using polycrystalline silicon (p-Si), instead of amorphous silicon (a-Si) which has been frequently used, and annealing is performed using laser beams for formation or growth of p-Si crystal grains. In general, p-Si has a higher mobility compared with a-Si, a TFT is downsized, and a high aperture ratio display and a high resolution display are realized. Moreover, since a gate self-aligning structure can be constructed, a TFT can be extremely small, the parasitic capacitance can be reduced, and the TFT can be operated at a high speed. Furthermore, in the structure, the electric complementary connection structure of an n-ch TFT and a P-ch TFT, i.e. CMOS, can be formed, and a high-speed drive circuit can be constituted. Therefore, by forming a drive circuit area integrally with a display area on the same substrate, manufacturing cost can be reduced, and an LCD module can be downsized.

Examples of a method of forming a p-Si film on an insulating substrate include crystallization by annealing a-Si generated at a low temperature, solid phase crystallization in a high-temperature state, and the like, but in either case, processing is performed at a temperature of 600°C or higher. Therefore, an inexpensive non-alkali glass substrate cannot be used as the insulating substrate in view of heat resistance, an expensive quartz glass substrate is necessary, and this adds to the manufacturing costs. To solve this problem, a method is developed in which the non-alkali glass substrate can be used as the insulating substrate by performing silicon poly-crystallization processing at a relatively low substrate temperature of 600°C or less using laser annealing. Such a process in which the processing temperature is 600°C or lower in all TFT substrate manufacture processes is called a low-temperature process, which is a requisite process for LCD mass production at a low cost.

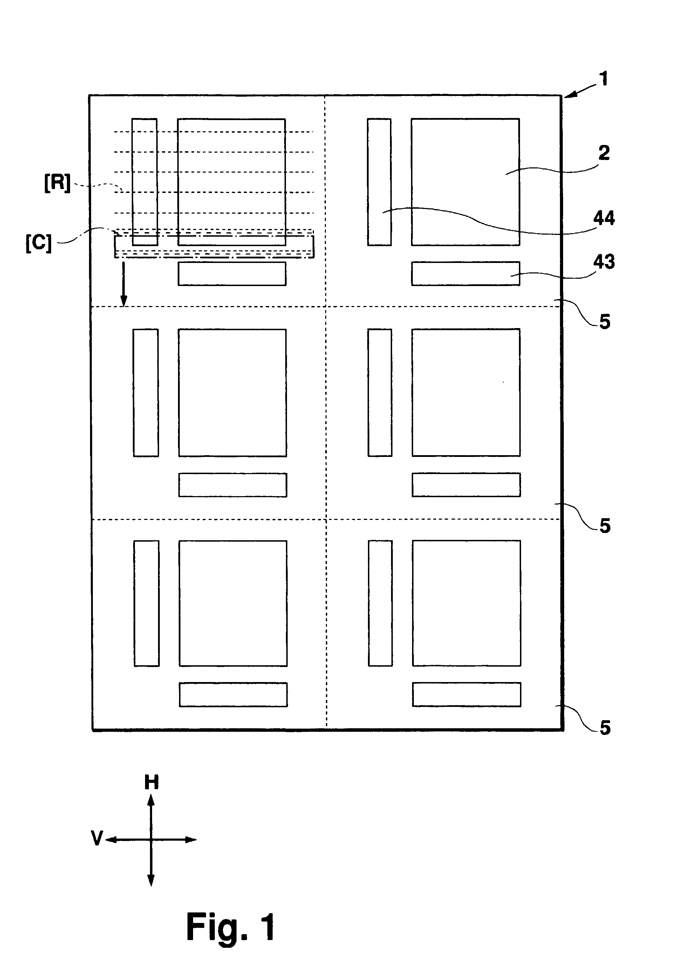

Fig. 1 is a plan view showing a relationship between a processed substrate 1 and a radiating and scanning direction of excimer laser in excimer laser annealing (ELA) which is realized by a laser beam radiating apparatus. The processed substrate 1 is an ordinary non-alkali glass substrate, and a-Si is formed on a surface thereof. The substrate 1 is a mother glass substrate including six pieces of active matrix substrate 5 constituting an LCD. Each active matrix substrate 5 is constituted of a display area 2 in which pixels are arranged/formed in a matrix in a main portion, a gate driver 43 forming a scanning drive circuit disposed/formed beside the display area 2, and a drain driver 44 forming a display drive circuit in the same manner. In the display area 2, pixel electrodes each forming one electrode of a pixel capacitor for operating a liquid crystal are to be arranged/formed in a matrix, and a TFT is connected to each of the pixel electrodes. The gate driver 43 is mainly constituted of a shift register, while the drain driver 44 is mainly constituted of a shift register and a sampling circuit. The drivers 43 and 44 are each to be formed by a TFT array of CMOS or the like.

To poly-crystallize a-Si to p-Si, pulse laser beams are radiated onto the substrate 1 with a-Si formed thereon using the laser beam radiating apparatus to perform annealing. Each radiated pulse laser beam has an edge C as shown in Fig. 1, and is a line beam with a line width of 0.5 to 1.0 mm and a line length of 80 to 150 mm. By moving the line beams on the processed substrate 1 while they are overlapped with one another by predetermined amounts, the entire substrate is irradiated with the laser beams, and a large area is processed, so that a-Si is poly-crystallized.

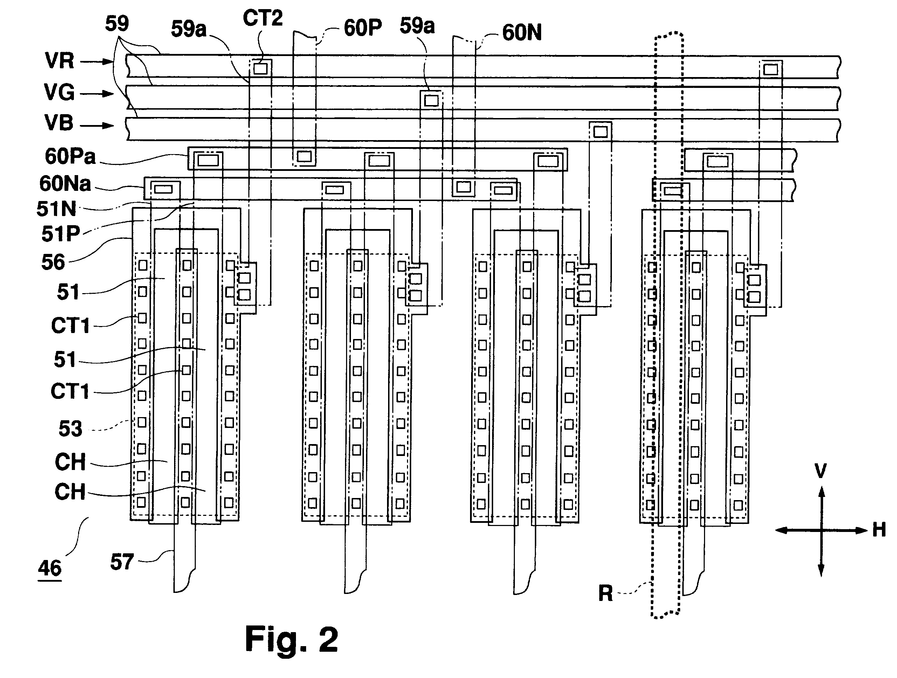

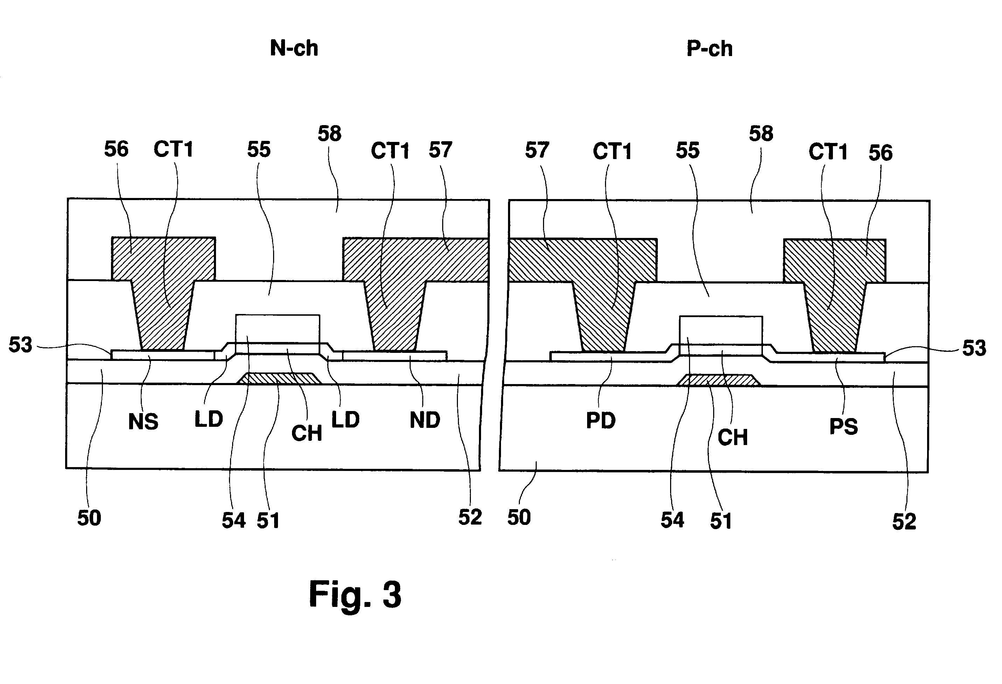

Fig. 2 is a partial plan view of the processed substrate 1 formed as aforementioned, and particularly a plan view of a sampling circuit area of the drain driver 44. The sampling circuit is constituted of a sampling transfer gate 46 in which each column is constituted of N-ch TFT and P-ch TFT. Fig. 3 is a sectional view of such TFTs; showing N-ch on the left side and P-ch on the right side. Gate electrodes 51 are formed on substrates 50, and connected to an output and a reverse output of each output stage of the shift register (not shown) formed in an upper portion of Fig. 2 via a lead line 60Na and a sampling line 60N on the N-ch side and via a lead line 60Pa and a sampling line 60P on the P-ch side, respectively. A gate insulating film 52 is formed substantially on the entire surface of the substrate 50 to cover the gate electrodes 51, and p-Si films 53 formed by ELA are formed in island patterns in a region including a portion above the gate electrodes 51 on the gate insulating film 52.

For N-ch, the p-Si film 53 includes a non-doped channel region CH directly above the gate electrode 51, lightly doped regions LD in which N-type impurities are doped in a low concentration on both sides of the channel region CH, and further highly-concentration doped source and drain regions NS and ND outside the regions LD. Moreover, for P-ch, the p-Si film 53 includes a non-doped channel region CH directly above the gate electrode 51, and source and drain regions PS and PD in which P-type impurities are doped in a high concentration on both sides of the region CH.

Implantation stoppers 54 used for forming the lightly-doped regions LD and the source and drain regions PS and PD are left on the channel regions CH of the p-Si films 53, and a first interlayer insulating film 55 is formed on the entire surface to cover the p-Si films 53 and the implantation stoppers 54.

Source electrodes 56 connected to video lines 59 to which R, G and B video signals are supplied via lead lines 59a and drain electrodes 57 extended to the display area 2 are formed on the first interlayer insulating film 55, and connected to the source regions NS and PS and the drain regions ND and PD via contact holes CT1 formed in the first interlayer insulating film 55, respectively.

A second insulating film 58 having a planarizating action is formed on the entire surface to cover the portions described above. In the display area 2, a TFT connected to each pixel is an N-ch TFT which has the same structure as the N-ch TFT shown in Fig. 3, but pixel electrodes for operating the liquid crystal are formed on the planarizating insulating film 58 and connected to the source electrodes 56 via contact holes formed in the planarizating insulating film 58.

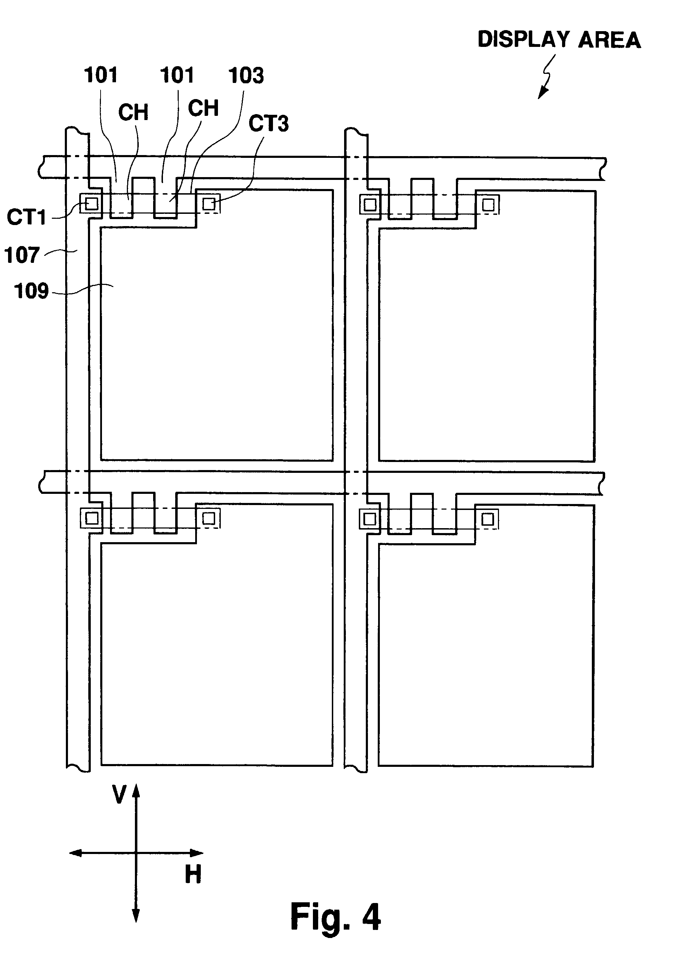

Fig. 4 is a partial plan view of the display area 2 of the processed substrate 1. Numeral 101 denotes gate electrodes extended vertically from gate lines arranged horizontally, 103 denotes a p-Si film with the gate insulating film therebetween extending across the gate electrodes 101, 107 denotes a drain electrode extended vertically, and 109 denotes a pixel electrode for operating the liquid crystal. The gate electrode 101, the p-Si film 103 and the drain electrode 107 are respectively formed by the same material films as the gate electrode 51, the p-Si film 53 and the drain electrode 57 of the sampling TFT 46 shown in Fig. 2. Especially, the drain electrode 107 is formed integrally with the drain electrode 57.

As shown in Fig. 2, the channel region CH of the sampling TFT 46 is elongated in which the channel width is larger than the channel length, the elongated channel region CH is disposed along a vertical direction V, and a plurality of sampling TFTs 46 formed in this manner are arranged in a horizontal direction H. Specifically, the sampling TFT 46 of the drain driver 44 and the TFT of the display area 2 are oriented in the same channel direction.

In the p-Si film formed by the excimer laser annealing (ELA), a region having an insufficiently large grain size or being inferior otherwise in crystallizability is generated in linear form along a longitudinal direction of linear pulse laser beams, and provides a striped pattern as shown by R in Fig. 1.

Such p-Si defective crystallized region R film has an inferior crystallizability, and the characteristics of a TFT formed in a region including the region R are generally deteriorated.

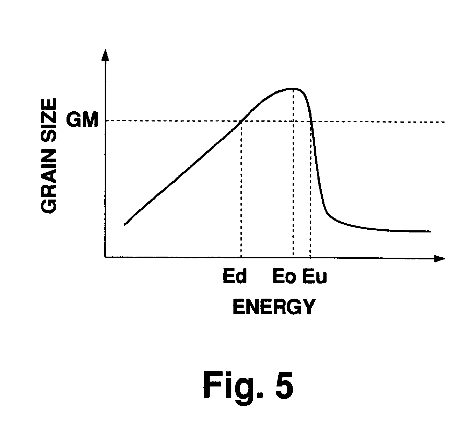

It is assumed that the region locally having an inferior crystallizability is generated for reasons described below. When a-Si is crystallized by ELA to form p-Si, laser energy and grain size have a relationship as shown in Fig. 5. Fig. 5 shows that as energy increases up to a certain energy value, the grain size is enlarged, but when energy Eo giving the maximum grain size is exceeded, the grain size is rapidly decreased. Therefore, to obtain a desired grain size GM or a larger grain size, the radiated laser energy has to be within a range between an upper limit Eu and a lower limit Ed.

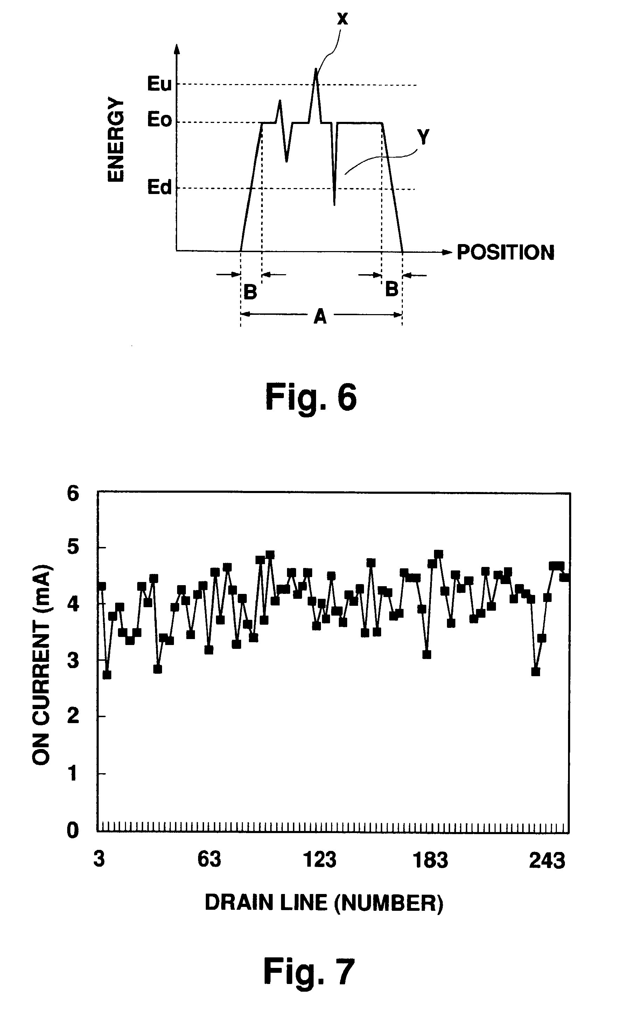

As shown in Fig. 6, however, a radiated beam intensity distribution of radiated line beams relative to positions is not completely flat in a beam line width section A. In Fig. 6, a portion in which the intensity is significantly raised or lowered exists, as shown by X or Y, and in such position the energy for obtaining the optimum grain size deviates from an allowable range [Ed-Eu].

The oversize and under radiation energies X and Y are generated in this manner mainly because foreign particles or the like adhering to lenses constituting an optical system of the laser radiating apparatus cause light shielding, diffraction, interference, and the like, and generate irregularities in intensity. Furthermore, when laser beams are converged in a line width direction in the optical system, the irregular beams may also be converged and expanded in a line length direction. Even when a small amount of foreign particles causing light irregularities in this manner exist, for example, in a clean room, optical characteristics are influenced, and the flat property of the intensity distribution is deteriorated. It is difficult at present to completely prevent the adherence of foreign particles and make the characteristics of Fig. 6 completely flat. Therefore, the formation of the region having inferior crystallizability in the longitudinal direction of linear pulse beams cannot be avoided.

Furthermore, dispersion may be generated in irradiation energy even during several shots of pulse laser beams, and the defective crystallized region R is generated irregularly on the processed substrate 1.

Fig. 7 shows a result of examination of relationship between a position of the sampling TFT 46 having the structure shown in Fig. 2 and ON current. The abscissa axis indicates the column number of the sampling TFT 46, while the ordinate axis indicates ON current values. It can be seen from Fig. 7 that the ON current is largely dispersed in a range from 3 mA to 5 mA.

It is assumed that such periodic dispersion of ON current is caused for the reasons described below.
Specifically, as shown in Fig. 1, the linear defective crystallized region R is generated in the vertical direction V (vertical scan direction V) of the plane of the substrate 1. On the other hand, as shown in Fig. 2, the sampling TFTs 46 include the vertically long channel regions CH in the same direction as the defective crystallized regions R, and are arranged in the horizontal direction H. Therefore, as shown in Fig. 2, in a case where the defective crystallized region R occupies a large part of the channel region CH of the sampling TFT 46, the TFT characteristics are significantly deteriorated. Furthermore, even if defective crystallized region R occupies only small part of channel region CH as to area, when the region R occupies large part of channel region R as to channel width direction, effective channel become narrow and the TFT characteristics are significantly deteriorated.

In a column formed in this manner in which the ON current is insufficiently large, a delay is generated in a display signal when the display signal is sampled from the video signals. Contrast ratio and brightness are lowered, and vertical streaks are observed on the display image plane, thereby deteriorating display quality level.

### SUMMARY OF THE INVENTION

The present invention has been developed to solve the problem, and an object thereof is to provide a semiconductor device with good characteristics in which a plurality of semiconductor elements are formed on a substrate. In some or all of the semiconductor elements, a channel width of a channel region formed in a laser-annealed semiconductor layer is larger than a channel length, and a channel width direction is formed in a direction different from a side direction of the substrate.

In another aspect of the present invention, a display comprises, a plurality of pixel electrodes arranged on a substrate, a plurality of first thin-film transistors connected to corresponding pixel electrodes among the plurality of pixel electrodes for supplying signals for operating pixels to the connected pixel electrodes, and a plurality of second thin-film transistors constituting a scanning drive circuit for scanning the plurality of first thin-film transistors and/or a display drive circuit for supplying display signals to the plurality of first thin-film transistors. In some or all of the plurality of second thin-film transistors, a channel width of a channel region formed in a laser-annealed semiconductor film is larger than a channel length thereof, and a channel width direction is formed in a direction different from a side direction of the substrate.

Moreover, in the display of the present invention, among the plurality of second thin-film transistors, some or all of second thin-film transistors in which the channel width is larger than the channel length and the channel width direction is formed in a direction different from the side direction of the substrate are used, in the display drive circuit, as sampling transistors for sampling video signals at a predetermined timing and supplying the display signals to the corresponding plurality of first thin-film transistors.

In the present invention, the display drive circuit is provided with, for example, a video signal line to which the video signals are supplied from outside, the sampling transistors, and a shift register for controlling switching operation of the sampling transistors. In another aspect of the present invention, for example, the second thin-film transistors formed in the relationship described above are used in the sampling transistors and the shift register.

When laser annealing is applied to the semiconductor layer to enhance film quality, for example, to change an amorphous semiconductor to a polycrystalline semiconductor, the laser annealing process is usually performed parallel with or orthogonal to the side direction of the substrate in relation to the manufacture process. In the laser annealing process, a defective processed region resulting from dispersion in annealing conditions tends to be generated parallel with or orthogonal to the laser scanning direction, i.e., parallel with or orthogonal to the side direction of the substrate. Since pixels are usually arranged or wiring is formed along the side direction of a square substrate or the like for use in the liquid crystal display or the like, the semiconductor elements or the second thin-film transistors are also formed along the side direction of the substrate.

In the present invention, however, in consideration of the above, the substrate side direction and the channel width direction of the semiconductor elements or the second thin-film transistors are formed so as not to coincide with each other.

Therefore, even if the defective region is formed in the semiconductor layer, the direction in which the region is extended fails to coincide with the element channel width direction, and the defective processed region does not decrease channel and extends across a plurality of elements. Therefore, the defective processed region does not deteriorate characteristics of elements and can be prevented from being concentrated on a single element or a small number of elements, thereby preventing the characteristics of the entire device from being deteriorated. For example, in the liquid crystal display or the like, when a certain sampling transistor is selectively formed in the defective processed region, the display quality of the column of display image is different from that of another column, and the display quality of the entire display is deteriorated somewhat. However, in the present invention, the defective processed region can be dispersed to a plurality of thin-film transistors, which contributes to enhancement of the display quality of the entire display.

According to a still further aspect of the present invention, in a semiconductor device in which a plurality of semiconductor elements are formed on a substrate, in some or all of the semiconductor elements, a channel width of a channel region formed in a laser-annealed semiconductor layer is larger than a channel length, and a channel width direction is formed in a direction different from a major-axis direction or a minor-axis direction of a laser-beam irradiated region at the time of laser annealing.

According to another aspect of the present invention, a display, as aforementioned, comprises a plurality of pixel electrodes, a plurality of first thin-film transistors, and a plurality of second thin-film transistors constituting a scanning drive circuit for scanning the plurality of first thin-film transistors and/or a display drive circuit for supplying display signals to the plurality of first thin-film transistors. In some or all of the plurality of second thin-film transistors, a channel width of a channel region formed in a semiconductor film to which laser annealing is applied is larger than a channel length thereof, and a channel width direction is formed in a direction different from a major-axis direction and/or a minor-axis direction of a laser-beam irradiated region at the time of application of the laser annealing.

Furthermore, in the display of the present invention, some or all of second thin-film transistors are used, in the display drive circuit, as sampling transistors for sampling video signals at a predetermined timing and supplying the display signals to the corresponding plurality of first thin-film transistors.

Moreover, the display drive circuit is provided, for example, with a video signal line to which video signals are supplied from outside, the sampling transistors, and a shift register for controlling switching operation of the sampling transistors. In another aspect of the present invention, for example, the second thin-film transistors formed in the relationship described above are used in the sampling transistors and the shift register.

In this case, since the defective laser-annealed region is generated parallel with edge lines of the irradiated region, the defective region is necessarily generated across a plurality of element regions formed in an oblique direction. This prevents the problem that channel width of elements decrease and that the deterioration of characteristics is concentrated on a single element or a small number of elements and the entire device becomes defective. Specifically, the deterioration of characteristics is dispersed to a plurality of or a large number of elements, the deterioration of characteristics of individual elements is small within an allowable range, and the entire device becomes non-defective.

According to still another aspect of the present invention, a liquid crystal display, as aforementioned, comprises a plurality of pixel electrodes, a plurality of first thin-film transistors, and a plurality of second thin-film transistors constituting a scanning drive circuit for scanning the plurality of first thin-film transistors and/or a display drive circuit for supplying display signals to the plurality of first thin-film transistors. Channel regions of the plurality of first and second thin-film transistors are formed in a laser-annealed semiconductor film, channel widths of some or all of the plurality of second thin-film transistors are larger than channel lengths, and channel width directions of some or all of the second thin-film transistors are formed non-parallel with and non-orthogonal to channel width directions of the first thin-film transistors.

Furthermore, in the liquid crystal display of the present invention, some or all of second thin-film transistors are used in the display drive circuit as sampling transistors for sampling video signals at a predetermined timing and supplying the display signals to the corresponding plurality of first thin-film transistors.

Moreover, the display drive circuit is provided, for example, with a video signal line to which the video signals are supplied from outside, the sampling transistors, and a shift register for controlling switching operation of the sampling transistors. Furthermore, for example, the second thin-film transistors formed in the relationship described above are used in the sampling transistors and the shift register.

In this case, even if the defective laser-annealed region is generated occupying a large part of the channel regions of the first thin-film transistors, the defective laser-annealed region is formed to obliquely cross the channel regions of the second thin-film transistors constituting the display drive circuit, and extends across only a part of the channel regions. Therefore, in terms of prevention of display quality deterioration of the liquid crystal display, for the second thin-film transistors of the display drive circuit which are more influenced by the existence of the defective processed region than the first thin-film transistors, the deterioration of characteristics by the defective processed region can be suppressed.

Additionally, the channel width direction of the channel region of the semiconductor element or the second thin-film transistor described above may be set, for example, to a direction of 45° relative to the substrate side direction or the major-axis direction and/or the minor-axis direction of the laser-beam irradiated region.

### BRIEF DESCRIPTION OF THE DRAWINGS

Fig. 1 is a diagram showing a layout of each circuit element on a processed substrate of p-Si TFT LCD and a positional relationship between the processed substrate and a line-beam irradiated region.

Fig. 2 is a plan view showing a planar structure of a sample holding TFT area of a drain driver area 4 of Fig. 1.

Fig. 3 is a sectional view showing a structural example of TFT of Fig. 2 in a TFT LCD.

Fig. 4 is a plan view showing a constitution of a display area of an active matrix type LCD.

Fig. 5 is a graph showing a relationship between an irradiation laser energy in ELA and an obtained p-Si grain size.

Fig. 6 is a graph showing an energy distribution in a direction of beam width A of irradiation laser beams.

Fig. 7 is a graph showing a relationship between a position of a TFT element group on related-art LCD substrate and characteristics.

Fig. 8 is a diagram showing a layout of each circuit element on a processed substrate of an LCD according to an embodiment of the present invention and a positional relationship between the processed substrate and a line-beam irradiated region.

Fig. 9 is a plan view showing a structural example of an LCD driver area according to the embodiment of the present invention.

Figs. 10, 11, 12, 13, 14, 15, 16, 17, 18 and 19 are sectional views showing processes of an LCD manufacturing method according to the embodiment of the present invention.

Fig. 20 is a diagram showing a constitution of a laser beam radiating device for use in the embodiment of the present invention.

Fig. 21 is a graph showing a relationship between a position of a TFT element group on an LCD substrate and characteristics according to the embodiment of the present invention.

### DESCRIPTION OF THE PREFERRED EMBODIMENT

A preferred embodiment of the present invention will be described with reference to the accompanying drawings. Additionally, constituent parts corresponding to the constitution described above are denoted with the same numerals and the description thereof is omitted.

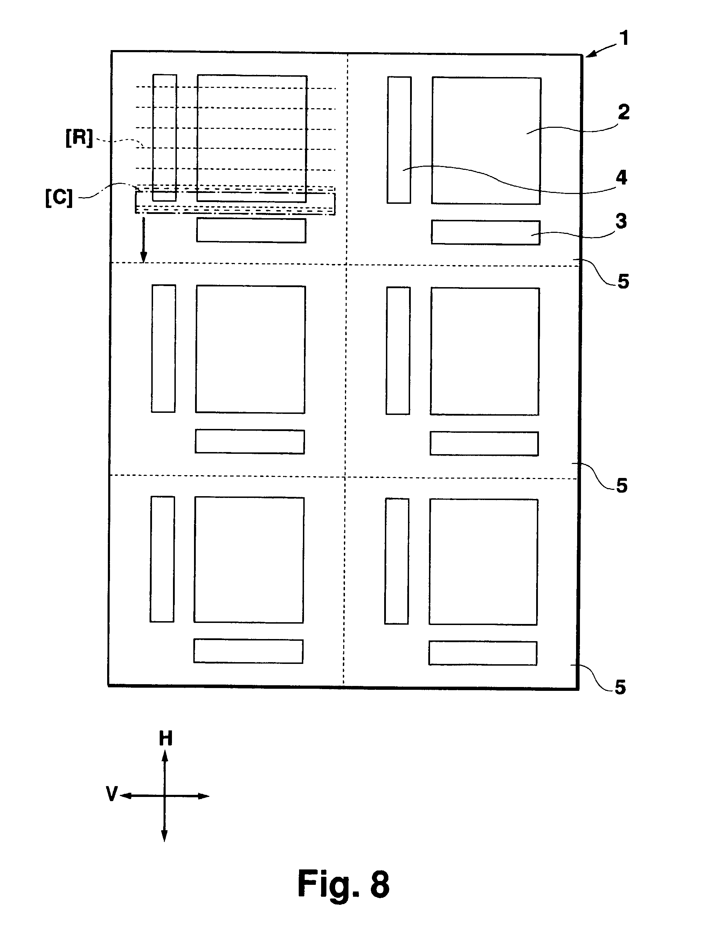

A driver built-in type p-Si TFT LCD is formed using a plurality of active matrix substrates 5 simultaneously formed from a large-sized processed substrate 1 (mother substrate) as shown in Fig. 8. Through various manufacturing processes of each active matrix substrate 5 of Fig. 8, a display area 2 is formed, and simultaneously a gate driver 3 and a drain driver 4 are formed along a vertical direction V and a horizontal direction H of the display area 2, respectively. Additionally, Fig. 8 diagrammatically shows a process in which after an a-Si film is formed on the substrate 1, pulse laser beams are radiated in outer configurations as shown by C using a laser radiating apparatus described later to poly-crystallize a-Si and form a p-Si film. In LCD, the gate driver 3 is mainly constituted of a shift register, and the drain driver 4 is mainly constituted of a shift register and a sampling circuit. The drivers 3 and 4 are each to be formed by a TFT array of CMOS constitution or the like formed using p-Si which is obtained by poly-crystallizing a-Si.

Additionally, the vertical direction V and the horizontal direction H shown in Fig. 8 and subsequent drawing and described below coincide with a vertical scanning direction and a horizontal scanning direction in LCD obtained in this manner.

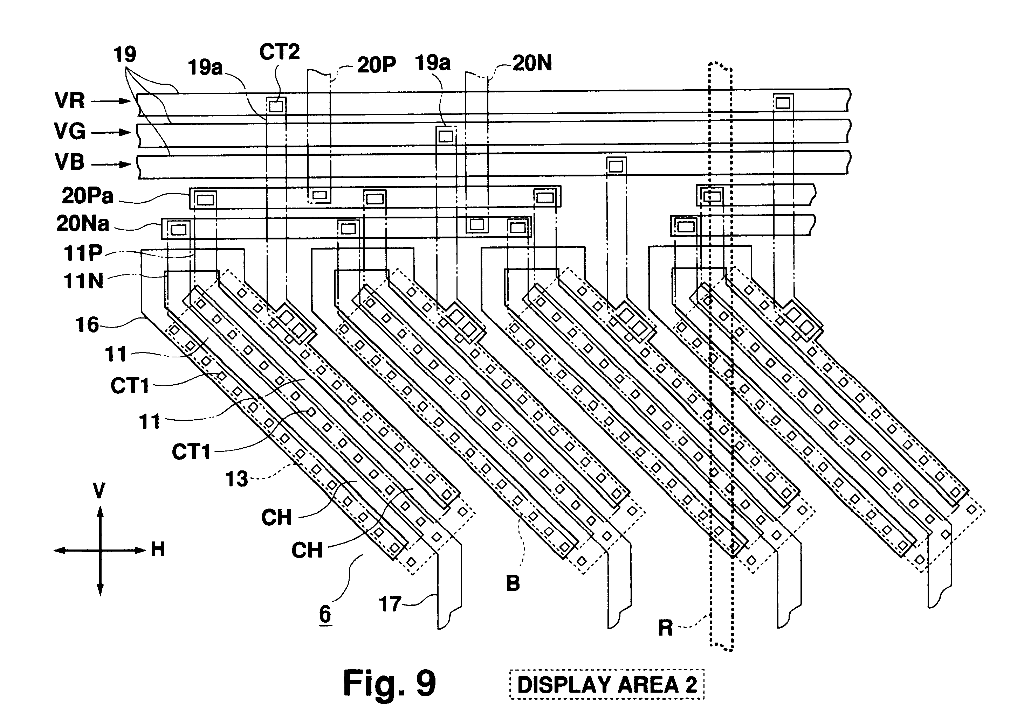

Fig. 9 is an enlarged plan view of a drain driver area, especially a sampling circuit area of the driver built-in type p-Si TFT LCD according to the embodiment using p-Si which is formed by poly-crystallizing a-Si as shown in Fig. 8.

In Fig. 9, numeral 19 denotes video lines to which R, G and B video signals are supplied; numerals 20N and 20P denote sampling lines connected to an output and a reverse output of each output stage of the shift register (not shown) formed in an upper portion of Fig. 9; and 6 denotes a sampling TFT which samples a display signal corresponding to each column from the video signals supplied to the video lines 19 in response to sampling signals supplied to the sampling lines 20N and 20P. Numeral 17 denotes a drain line extended to the display area 2, which receives the display signal sampled by the sampling TFT 6 to transmit the signal to each pixel.

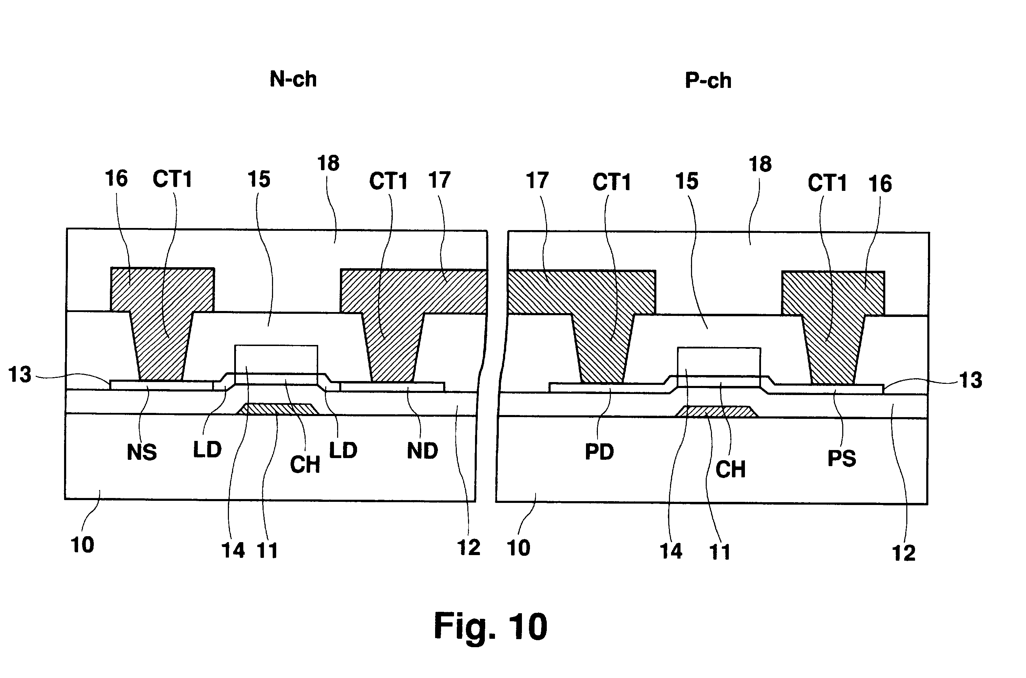

Fig. 10 is a sectional view of a TFT prepared on the processed substrate 1 of Fig. 8, e.g., the sampling TFT (CMOS constitution) of Fig. 9. The left side shows N-ch, and the right side shows P-ch. The sampling TFT 6 of Fig. 9 functions as a transfer gate constituted of N-ch and P-ch as will be described later. Gate electrodes 11 constituted of Cr or the like are formed on a non-alkali glass substrate 10, and a gate insulating film 12 constituted of SiNx, SiO₂, or the like is formed to cover the entire surface. On the gate insulating film 12, p-Si films 13 are formed using ELA in regions covering the gate electrodes 11.

For N-ch, the p-Si film 13 includes a non-doped channel region CH directly above the gate electrode 11, lightly doped regions LD in which n-type impurities are doped in a low concentration on both sides of the region CH, and further source and drain regions NS and ND in which n-type impurities are doped in a high concentration outside the regions LD. On the other hand, for P-ch, a non-doped channel region CH is formed directly above the gate electrode 11, and a source region PS and a drain region PD in which p-type impurities are doped in a high concentration are formed on both sides of the region CH.

Implantation stoppers 14 used for forming the lightly-doped regions LD and the source and drain regions PS and PD are present on the p-Si films 13. A first interlayer insulating film 15 of SiNₓ or the like is formed on the entire surface to cover the p-Si films 13 and the implantation stoppers 14, and source electrodes 16 and drain electrodes 17 of A1/Mo or the like are formed on the first interlayer insulating film 15 and connected to the source regions NS, PS and the drain regions ND, PD via first contact holes CT1 formed in the first interlayer insulating film 15. A second interlayer insulating film 18 of SOG (spin on glass), BPSG (boro-phospho silicate glass), TEOS (tetraethyl ortho silicate), or the like is formed on the entire surface to cover the source and drain electrodes 16 and 17, as a planarizating insulating film.

The planar structure of the display area 2 is the same as that of Fig. 4. The TFT of the display area 2 is an N-ch TFT of the same structure as shown in Fig. 10, but a pixel electrode for operating the liquid crystal is formed on the planarizating insulating film 18 and connected to the source electrode 16 via the contact hole formed in the planarizating insulating film 18.

In this manner a TFT is used in a switching element for each pixel, and forms CMOS in the driver area 3 or 4. Especially in the present invention, the channel region CH of TFT in the driver area has an elongated configuration in which a channel width is sufficiently larger than a channel length. The island layer of the p-Si film 13 is formed in such a manner that the longitudinal direction of the elongate channel region CH is directed obliquely relative to both the vertical direction V and the horizontal direction H on the plane of the substrate 1. Additionally, in the display area 2 of the embodiment, the channel width of TFT is directed in the same manner as shown in Fig. 4, i.e., it remains in the vertical direction V as will be described later.

The sampling TFT 6 shown in Fig. 9 is a transfer gate in which the N-ch area and P-ch area shown in Fig. 10 are integrally formed and, as shown in Fig. 9, the p-Si film 13, the source electrode 16 and the drain electrode 17 of each gate are integrated with those of other gate.

In the sampling TFT 6, the channel width is designed sufficiently large to sample a signal voltage having an amplitude sufficient for operating the liquid crystal and apply the voltage to the drain line 17, and the channel region CH is elongated. The long-side direction of the elongated channel region CH is obliquely formed to have an angle of 45° relative to the vertical direction V or the horizontal direction H of the substrate plane.

The sampling line 20N or 20P is formed by the same material film as that of the gate electrode 11, while the video line 19 is formed by the same material film as that of the source or drain electrode 16 or 17. The N-ch area gate electrode 11 is connected to the sampling line 20N via a lead line 20Na constituted of the same material film as that of the source or drain electrode 16 or 17. The P-ch area gate electrode 11 is connected to the sampling line 20P via a lead line 20Pa constituted of the same material film as that of the source or drain electrode 16 or 17.

Additionally, the N-ch and P-ch drain electrodes 17 are formed integrally, and extending to the drain line of the display area 2. The N-ch and P-ch source electrodes 16 are also interconnected integrally and connected to the video line 19 via a lead line 19a constituted of the same material film as that of the gate electrode 11. The interlayer connection is performed via second contact holes CT2 formed in the gate insulating film 12 and the first interlayer insulating film 15.

Video signals VR, VG and VB supplied to the video lines 19 are further supplied to the source electrodes 16 of the sampling TFT 6, and sampling pulses emitted from each output stage of the shift register (not shown) are supplied to the gate electrodes 11 via sampling lines 11N and 11P to turn on the sampling TFT 6. Sampling is performed at this timing, and a display signal is supplied to the corresponding drain electrode 17 and transmitted to the display area 2.

A method of manufacturing the p-Si TFT will next be described.

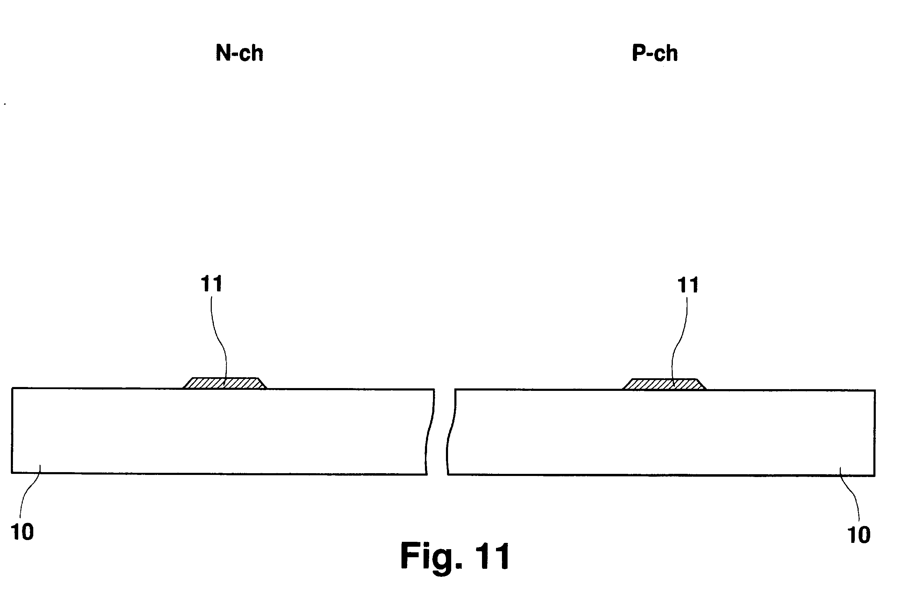

First, as shown in Fig. 11, a film is formed by sputtering Cr on the non-alkali glass substrate 10, and etched to form the gate electrodes 11, the lead lines 20N, 20P and the sampling lines 19a of TFT in the display area 2 and the drivers 3 and 4.

For the sampling TFT 6, as shown in Fig. 9, the gate electrodes 11 are elongated in the channel width direction, and directed obliquely relative to the vertical direction V and the horizontal direction H, for example, angle of 45°.

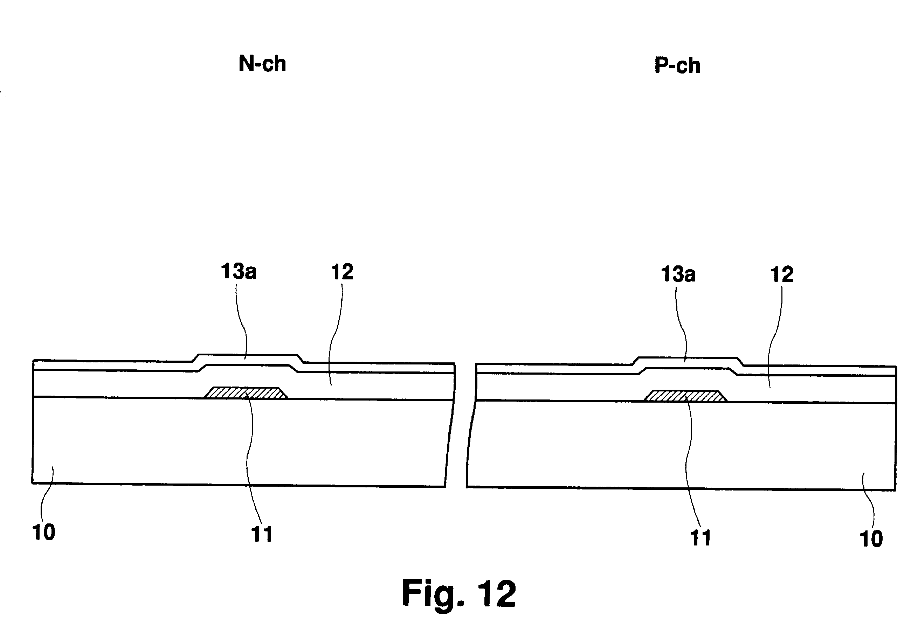

Subsequently, as shown in Fig. 12, the gate insulating film 12 constituted of SiNx and SiO₂ is formed on the entire surface to cover the gate electrodes 11, and the like by plasma CVD, and an amorphous silicon (a-Si) film 13a is successively formed by the plasma CVD. The a-Si film 13a is formed by decomposing and depositing source gas of mono-silane SiH₄ or di-silane Si₂H₆ by heat or plasma of about 400°C.

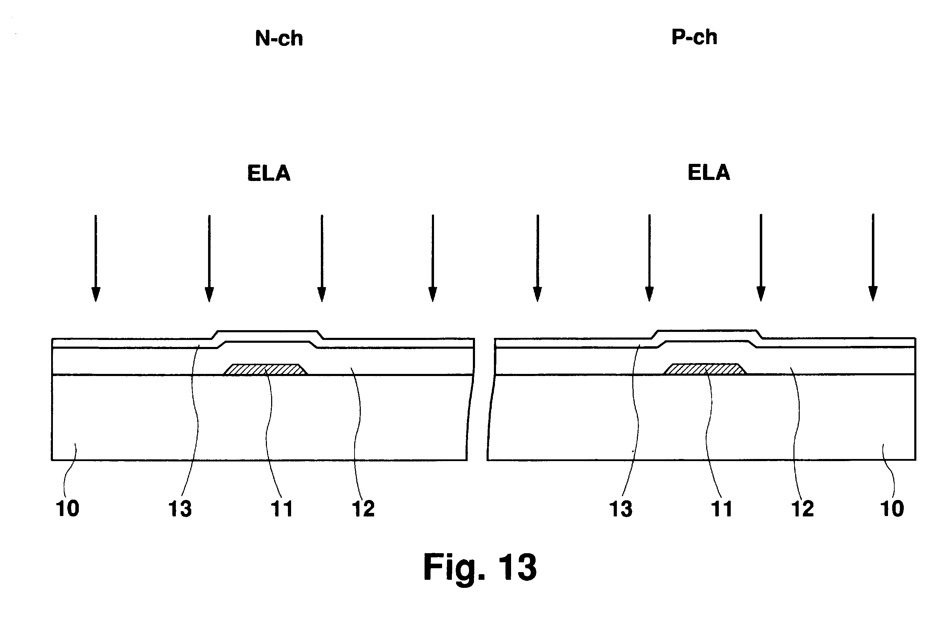

Thereafter, as shown in Fig. 13, by performing ELA at about 600°C, the a-Si film 13a is crystallized to form the p-Si film 13. ELA is performed by pulse-laser line beam scanning, but there are cases where a linear defective crystallized region R is left after line beams pass, as shown in Figs. 8 and 9.

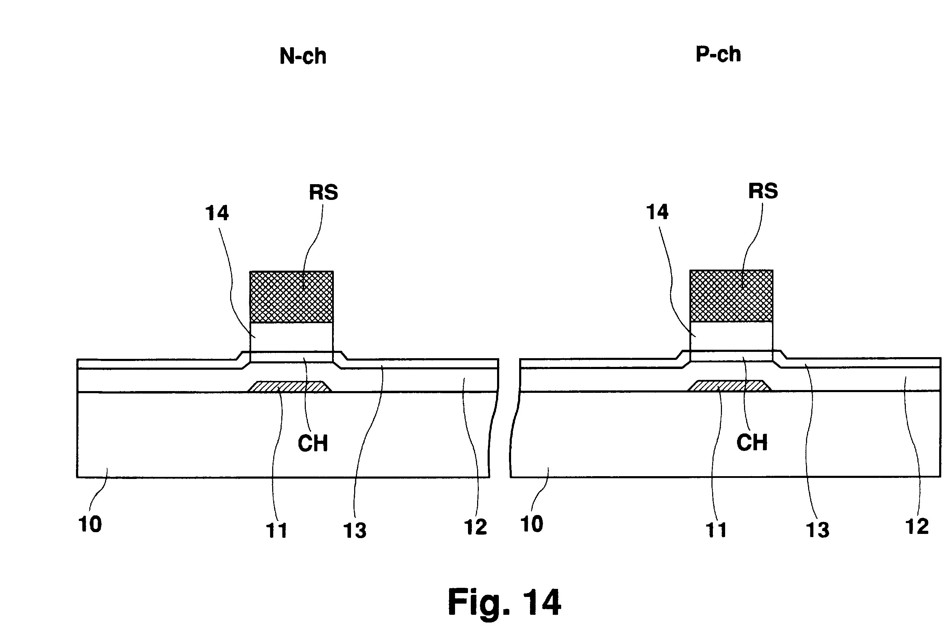

Subsequently, as shown in Fig. 14, SiO₂ film is formed on the substrate on which the p-Si film 13 is formed, and etched using a back-surface exposure method to form the implantation stoppers 14 above the gate electrodes 11. In the back-surface exposure, a resist RS is applied onto the SiO₂ film, exposure is performed from below the substrate 10, and regions other than shaded regions of the gate electrodes 11 are sensitized to perform development. Subsequently, etching is performed using the resist RS left after the development as a mask to form the implantation stoppers 14 in which patterns of the gate electrodes 11 are reflected.

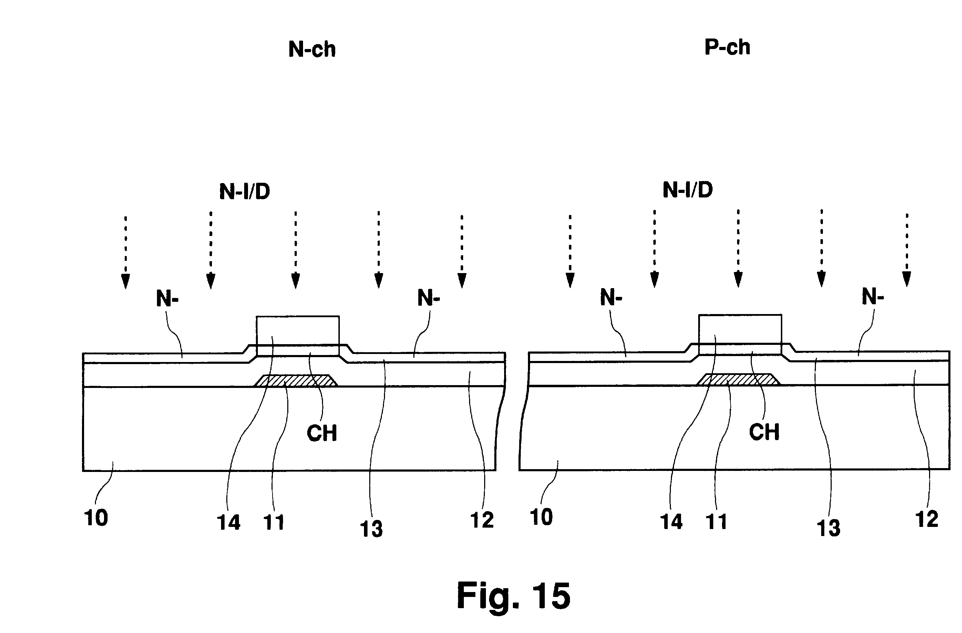

The implantation stoppers 14 are used as masks and, as shown in Fig. 15, phosphorous (P) ions indicating N-type conductivity are doped to the p-Si film 13 in a small dose of about 10¹³, and a region not covered with the implantation stoppers 14 is doped in a low concentration (N-). At this time, the regions directly under the implantation stoppers 14, i.e., the regions directly above the gate electrodes 11 are maintained as intrinsic layers, which form the TFT channel regions CH. The resist used for etching the implantation stoppers 14 may be left at the time of ion doping and peeled off after the ion doping.

Additionally, as aforementioned, in the sampling TFT 6, the channel region CH is elongated in the channel width direction, and its longitudinal direction is oblique relative to the vertical direction V and the horizontal direction H.

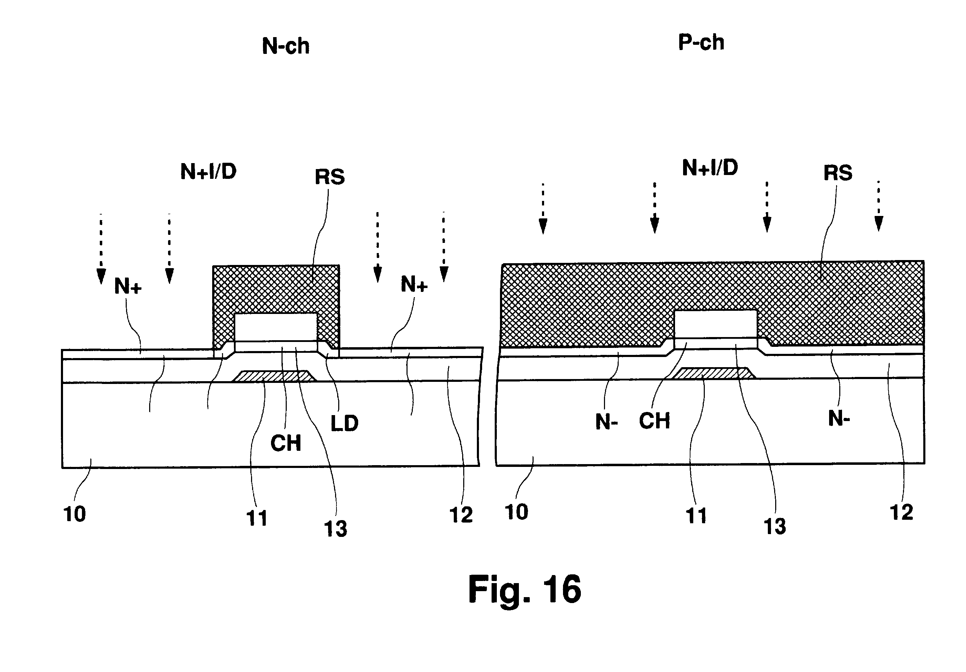

Subsequently, as shown in Fig. 16, on the N-ch area, a resist RS larger than the gate electrode 11 is formed, and used as a mask to dope phosphorous (P) ions to the p-Si film 13 in a high dose of about 10¹⁵ and to dope a region N+ other than the resist RS in a high concentration. At this time, the low concentration region N- and the channel region CH are maintained directly under the resist RS. Therefore, the low-concentration doped or lightly-doped regions LD are formed on both sides of the channel region CH, and the high-concentration doped source and drain regions NS and ND are further formed outside, to form an LDD structure. Additionally, at this time, the P-ch area is covered with a resist RS to prevent doping of N-type impurities.

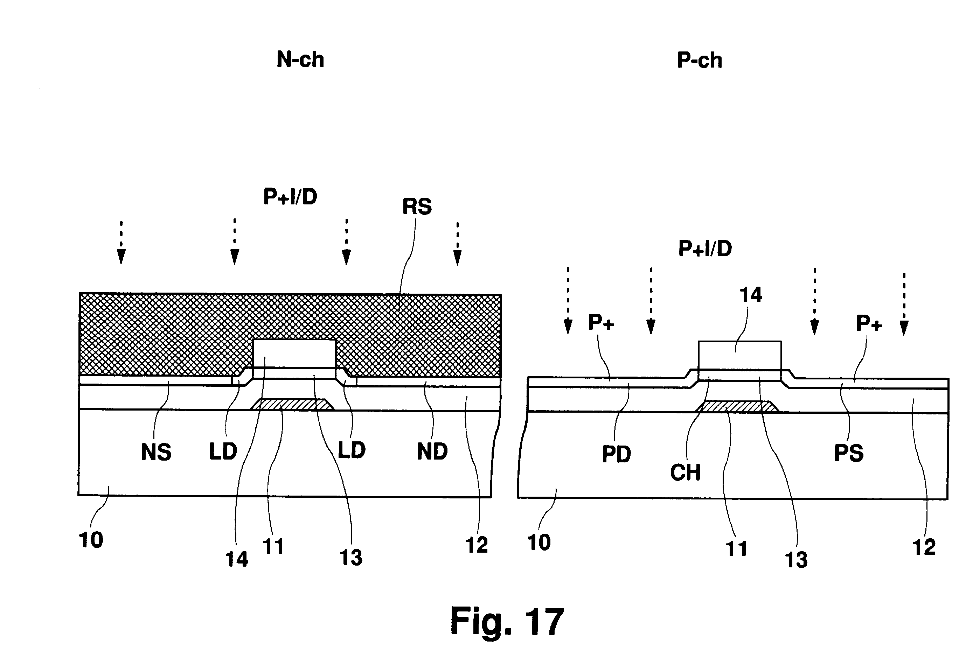

After stripping off the resists RS of Fig. 16, as shown in Fig. 17, another resist RS is formed on the N-ch area and, in this state, ion implantation of boron and other P-type impurities to the p-Si film 13 is performed at a level of about 10¹⁵. Thereby, the intrinsic layer of channel region CH is formed directly under the implantation stopper 14, and its both-side regions P+ are doped in P type of a high concentration, so that the P-ch TFT source and drain regions PS and PD are formed.

After stripping off the resist RS shown in Fig. 17, heating, laser radiation, or another activation annealing is performed for the purpose of restoration of crystallizability of the p-Si film 13 doped with impurity ions and replacing of impurities to lattice position.

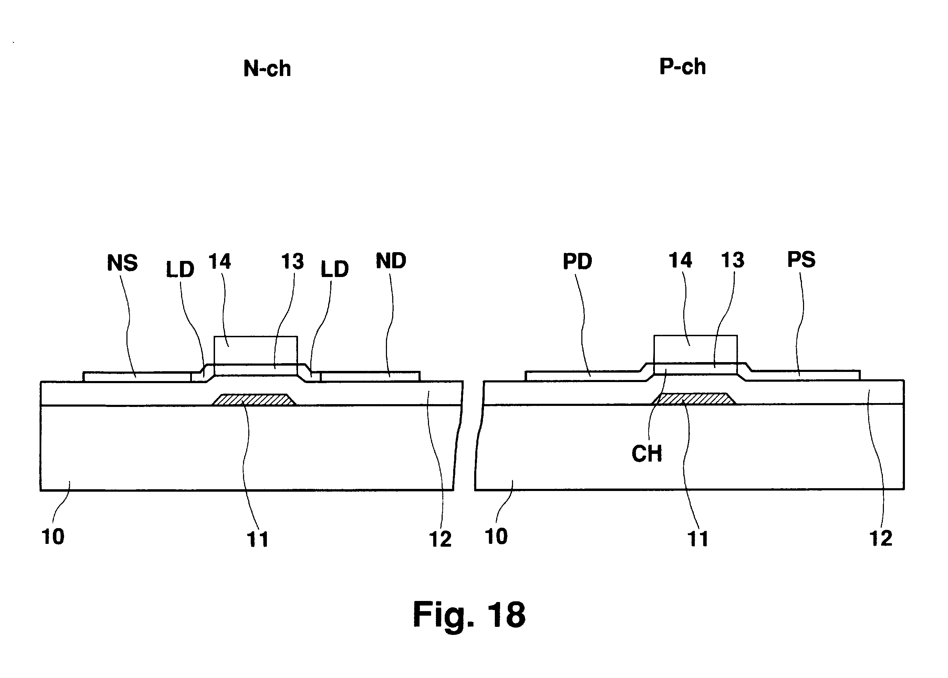

After the activation annealing, by etching the p-Si film 13 as shown in Fig. 18, the p-Si film 13 for the sampling TFT 6 is left in the configuration as shown in Fig. 9, and the p-Si film 13 for the display area 2 is left in the configuration as shown in Fig. 4, so that only the regions necessary for the TFT are formed in island configurations. Especially, for the sampling TFT 6, the island layer of the p-Si film 13 is elongated in the channel width direction, and directed 45° relative to the vertical direction V and the horizontal direction H in its longitudinal direction.

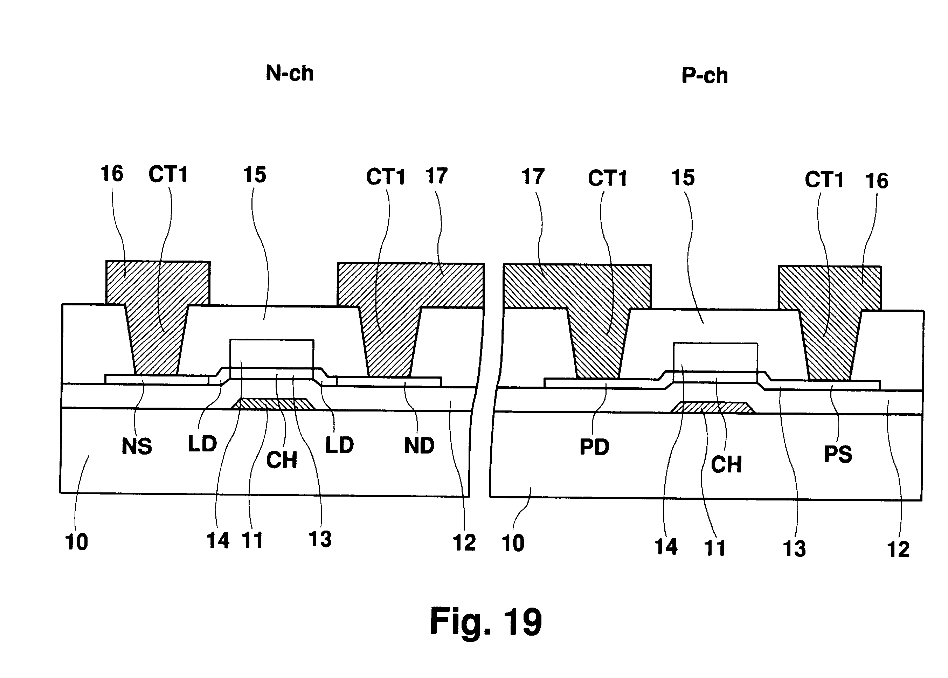

In the subsequent process, as shown in Fig. 19, a film of SiNₓ or the like is formed by plasma CVD to form the interlayer insulating film 15, and portions corresponding to the source and drain regions NS, PS, ND and PD of the insulating layer 15 are etched and removed to form the first contact holes CT1 and partially expose the p-Si films 13. Subsequently, Al/Mo are deposited by sputtering and etched to form the source electrodes 16 and the drain electrodes 17 and to connect the electrodes to the source regions NS, PS and the drain regions ND, PD, respectively, so that the TFT is completed. Moreover, the video lines 19 and the lead lines 20Pa and 20Na are simultaneously formed.

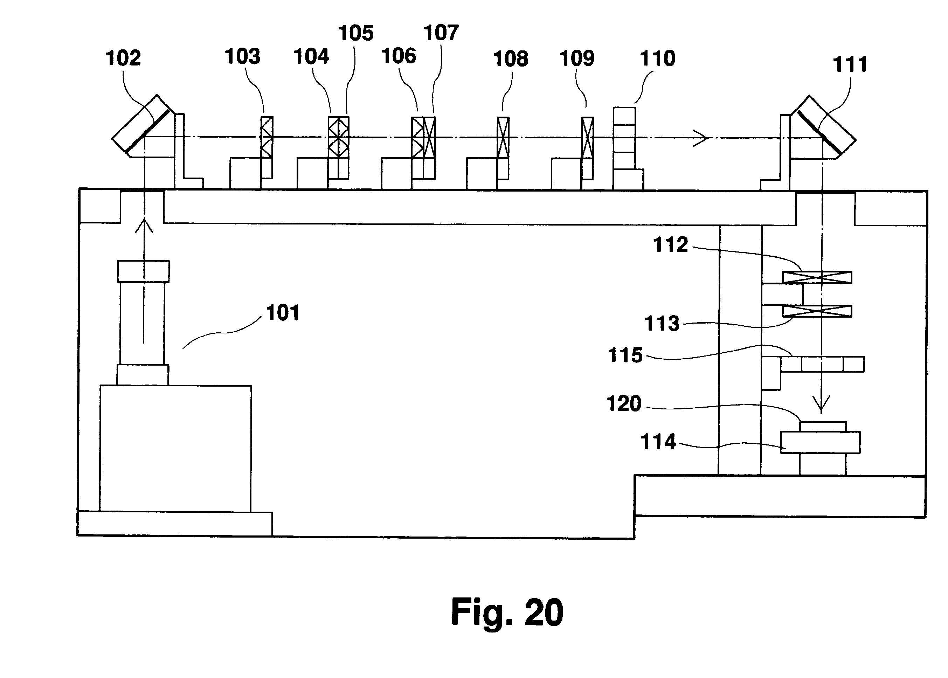

In the crystallization ELA process of Fig. 13, a laser beam radiating apparatus as shown in Fig. 20 is used. In Fig. 20, numeral 101 denotes a laser oscillation source; 102 and 111 denote mirrors; 103, 104, 105 and 106 denote cylindrical lenses; 107, 108, 109, 112 and 113 denote converging lenses; 110 denotes a slit in a line width direction; and 114 denotes a stage by which a processed substrate 120 having a-Si formed on its surface is supported. Additionally, numeral 115 denotes a slit in a line longitudinal direction, which is disposed close to the stage 114.

For example, excimer laser beams are used, and the laser beams radiated from the laser oscillation source 101 are transformed to parallel beams, in which an intensity output distribution is flat relative to vertical and scanning directions, by two pairs of capacitor lenses constituted of the cylindrical lenses 103, 105 and 104, 106. The parallel beams are converged in one direction by the lenses 108, 109, 112 and 113, and expanded in another direction by the lens 107 to form square, belt-like or practically linear beams (line beams) and irradiate the processed substrate 120. Additionally, the slits 110 and 115 define edge portions in the line width A and longitudinal directions to clarify the configuration of the irradiated region and to make the intensity of the effective irradiated region constant. The stage 114 on which the processed substrate 120 is laid is movable in directions X and Y, so that the irradiation line beams are scanned in the line width direction, and laser annealing is realized with a high throughput by large area processing.

The pulse laser beams radiated to the substrate 1 are shaped by the laser beam radiating apparatus described above in such a manner that the irradiated region has a linear, belt-like or square configuration, but dispersions of irradiation energy are generated along the sides of the beam radiating region in the shaped beams because of dust (particle) or the like adhering to the optical system. In the irradiated region of the p-Si film to which beams deviating from an allowable range of energy applied to obtain the optimum grain size are radiated, as shown in Fig. 8, the defective crystallized regions R are formed along the sides of the pulse laser beams.

If the sampling TFT 6 is formed on the defective crystallized region R, operation speed is reduced,
insufficient sampling is performed in the corresponding column, the amplitude of the display signal supplied to the drain line is reduced, the brightness or the contrast ratio is lowered for the same line, vertical streaks are conspicuous, and display quality level is disadvantageously lowered.

Since the laser-beam irradiated region is usually shaped on the basis of the sides of the processed substrate 1, the edges of the irradiated region are extended along the vertical direction V or the horizontal direction H of the substrate plane. Specifically, the side direction of the processed substrate 1 is generally the same as the major-axis direction of the defective crystallized region R.

As aforementioned with reference to Fig. 2, in the constitution in which the sampling TFTs elongated in the vertical direction V are continuously arranged in the horizontal direction H, the defective crystallized region R is generated in the same direction. Even if the defective crystallized region R passes on only a part of the region in which the sampling TFTs 6 are arranged, the characteristics are not deteriorated very much because the channel width of the sampling TFT 6 is large and only part of channel is not used, so channel width decreases a little. Moreover, in a case where the characteristics of all sampling TFTs 6 are similarly deteriorated, no difference in brightness and contrast ratio among columns is recognized. For these reasons, even if the defective crystallized region R is generated in the horizontal direction H, not much adverse effect is exerted on display.

In a case where the defective crystallized region R is generated in the vertical direction V of the substrate plane, however, the defective crystallized region R longitudinally extends across the channel region CH, and a large part of a TFT may be occupied by the defective crystallized region R. In this case, the sampling TFT 6 is inferior in characteristics to another sampling TFT 6 in which no defective crystallized region R exists, the brightness or the contrast ratio in the corresponding column on LCD is different from that in another column, vertical streaks are observed and adverse effect is exerted on display. However, under restrictions on manufacture and cost, for example, since a plurality of substrates 5 are cut from one substrate 1, it is difficult to set the layout of the drain driver 4 and the scanning direction of line beams to a relationship other than the relationship shown in Fig. 1 or 8. Therefore, in order to enhance the characteristics of the sampling TFT 46 shown in Fig. 2, a line beam radiating apparatus of a special structure has to be used. That apparatus is expensive.

On the other hand, in the embodiment of the present invention, as shown in Fig. 9, the channel width direction of the elongated sampling TFT 6 is different, e.g., it has an angle of 45° with respect to the vertical direction V or the horizontal direction H of the processed substrate 1, in other words, either side of the substrate 1 or 5. For example, the sampling TFT 6 has a channel length of 6 µm and a channel width of 300 µm, and is far longer in the channel width direction than the case shown in Fig. 9. On the region in which the sampling TFTs 6 are arranged without any gaps between them, the defective crystallized region R generated in the vertical direction V is actually extended across more sampling TFTs 6 than the case shown in Fig. 9, e.g., five to ten sampling TFTs 6. Specifically, since only a part of each sampling TFT 6 formed on the defective crystallized region R is included in the defective crystallized region R, the characteristics of each TFT is slightly lowered, but the characteristics on entire display can be prevented from being largely deteriorated. Moreover, since the deterioration of characteristics of TFT is so small, the deterioration of characteristics does not appear on display.

Therefore, even when the sampling TFTs 6 formed on the same substrate are affected, i.e., the drain driver 4 is directed in either the vertical direction V or the horizontal direction H, the defective crystallized region R is not generated in a single TFT or a small number of TFTs, and the concentration of deterioration of characteristics and the occurrence of display defect or the like of the display area are avoided, as long as the long-side direction of each sampling TFT 6 is different from the arrangement direction thereof. Consequently, the relationship between the direction of the drain driver 4 formed on the processed substrate 1, i.e., the direction of the active matrix substrate 5 taken from the processed substrate 1, and the scanning direction of line beams is not restricted, and manufacturing cost can be reduced.

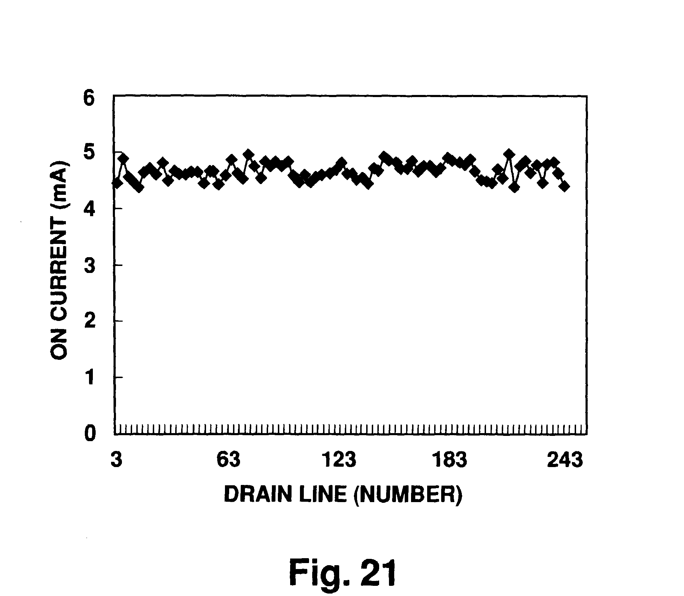

Fig. 21 shows a relationship between a position of the sampling TFT 6 having the structure of Fig. 9 and ON current. The abscissa axis indicates the column number (drain-line position), while the ordinate axis indicates ON current values. When comparing with Fig. 7 showing the conventional relationship in which ON current values are within a range from 4.3 to 5.0 mA for all TFTs 6, it is seen that ON current average value is improved and dispersion is remarkably suppressed. In Fig. 7, ON current is remarkably lowered in TFTs positioned on the defective crystallized region R and a large dispersion occurs overall, but in the embodiment, since the defective crystallized region R passes only a part of a TFT, the decrease of ON current is dispersed to a large number of peripheral TFTs as a result. Moreover, in the embodiment, it is not recognized that ON current is entirely lowered, and ON current average value tends to be somewhat enhanced. This is probably because even if one TFT partially abuts on the defective crystallized region R and its characteristics are slightly deteriorated, no decrease of ON current is caused at a substantial level.

Additionally, the layout of the present invention is not limited to the sampling TFT, and can be applied to all TFT elements formed on the same substrate in a region other than LCD driver area 4, a shift register area, a gate driver, and further in a timing generator, a video signal processing circuit, a memory, CPU, a sensor, and the like.

Moreover, in the present invention, for TFTs in the display area 2, as shown in Fig. 4, the channel width direction is designed the same as the LCD's vertical direction V (horizontal direction H as the case may be). This is because for TFTs of the display area 2, the channel width is not larger than the channel length, a large part of the channel region CH cannot be disengaged from the defective crystallized region R even if the channel width direction is tilted from the vertical direction V, and high-speed operation is not required so much by TFTs of the display area 2 compared with TFTs of the driver area 3 or 4. However, it is not prohibited to design the channel width direction of the TFT of the display area 2 different from the vertical direction V or horizontal direction H of the LCD.

Furthermore, in the present invention, TFT's channel width direction is not restricted to the direction of 45° relative to the substrate side, and set to a direction different from the major-axis or minor-axis direction of the laser-beam irradiated region. Therefore, the defective crystallized region generated in the major-axis or minor-axis direction of the irradiated region is prevented from being concentrated on the region of a single element or a small number of elements or the element region of the same system. Since the defective crystallized region is generated across a plurality of or a large number of elements, the deterioration of element characteristics is dispersed to the plurality of or the large number of elements, and display defect or operation defect is entirely prevented.

Moreover, the present invention is not limited to laser annealing for crystallization, and a problem resulting from unavoidably generated dispersion in energy is solved as aforementioned in laser annealing for activation or another purpose.

## Claims

1. A semiconductor device in which a plurality of semiconductor elements are formed on a substrate, wherein
in some or all of said semiconductor elements, a channel width of a channel region formed in a semiconductor layer to which laser annealing is applied is larger than a channel length thereof, and a channel width direction is formed in a direction different from a side direction of said substrate.

2. A semiconductor device in which a plurality of semiconductor elements are formed on a substrate, wherein
in some or all of said semiconductor elements, a channel width of a channel region formed in a semiconductor layer to which laser annealing is applied is larger than a channel length thereof, and a channel width direction is formed in a direction different from a major-axis direction and/or a minor-axis direction of a laser-beam irradiated region at the time of application of said laser annealing.

3. A display device comprising,
a plurality of pixel electrodes arranged on a substrate;
a plurality of first thin-film transistors connected to corresponding pixel electrodes among said plurality of pixel electrodes for supplying signals for operating pixels to the connected pixel electrodes; and
a plurality of second thin-film transistors constituting a scanning drive circuit for scanning said plurality of first thin-film transistors and/or a display drive circuit for supplying display signals to said plurality of first thin-film transistors, wherein
in some or all of said plurality of second thin-film transistors, a channel width of a channel region formed in a semiconductor film to which laser annealing is applied is larger than a channel length thereof, and a channel width direction is formed in a direction different from a side direction of said substrate.

4. A display device comprising,
a plurality of pixel electrodes arranged on a substrate;
a plurality of first thin-film transistors connected to corresponding pixel electrodes among said plurality of pixel electrodes for supplying signals for operating pixels to the connected pixel electrodes; and
a plurality of second thin-film transistors constituting a scanning drive circuit for scanning said plurality of first thin-film transistors and/or a display drive circuit for supplying display signals to said plurality of first thin-film transistors, wherein
in some or all of said plurality of second thin-film transistors, a channel width of a channel region formed in a semiconductor film to which laser annealing is applied is larger than a channel length thereof, and a channel width direction is formed in a direction different from a major-axis direction and/or a minor-axis direction of a laser-beam irradiated region at the time of application of said laser annealing.

5. A liquid crystal display device comprising,
a plurality of pixel electrodes arranged on one of a pair of substrate holding a liquid crystal therebetween;
a plurality of first thin-film transistors connected to corresponding pixel electrodes among said plurality of pixel electrodes for supplying signals for operating the liquid crystal to the connected pixel electrodes; and
a plurality of second thin-film transistors constituting a scanning drive circuit for scanning said plurality of first thin-film transistors and/or a display drive circuit for supplying display signals to said plurality of first thin-film transistors,
channel regions of said plurality of first and second thin-film transistors being formed in a semiconductor film to which laser annealing is applied, and
in some or all of said plurality of second thin-film transistors, a channel width being larger than a channel length, and a channel width direction of some or all of second thin-film transistors being formed non-parallel with and non-orthogonal to a channel width direction of said first thin-film transistors.

6. The liquid crystal display device according to claim 5 wherein
among said plurality of second thin-film transistors, in said some or all of second thin-film transistors in which the channel width direction is formed non-parallel with and non-orthogonal to the channel width direction of said first thin-film transistors,
the channel width direction is further formed in a direction different from a side direction of said substrate or in a direction different from a major-axis direction and/or a minor-axis direction of a laser-beam irradiated region at the time of application of said laser annealing.

7. The display device according to any one of claims 3 to 6 wherein
among said plurality of second thin-film transistors, said some or all of second thin-film transistors in which the channel width is larger than the channel length and the channel width direction is formed in a direction different from a side direction of said substrate or in a direction different from a major-axis direction and/or a minor-axis direction of a laser-beam irradiated region at the time of application of said laser annealing or formed non-parallel with and non-orthogonal to the channel width direction of said first thin-film transistors
are used, in said display drive circuit, as sampling transistors for sampling video signals at a predetermined timing and supplying said display signals to the corresponding plurality of first thin-film transistors.

8. The display device according to claim 7 wherein
said display drive circuit comprises a video signal line to which the video signals are supplied from outside, said sampling transistors, and a shift register for controlling switching operation of said sampling transistors.

9. The display according to any one of claims 3 to 6 wherein
said display drive circuit comprises:
a video signal line to which the video signals are supplied from outside, sampling transistors for sampling the video signals from said video signal line at a predetermined timing and supplying said display signals to the corresponding plurality of first thin-film transistors, and a shift register for controlling switching operation of said sampling transistors,
among said plurality of second thin-film transistors, said some or all of second thin-film transistors in which the channel width is larger than the channel length and the channel width direction is formed in a direction different from a side direction of said substrate or in a direction different from a major-axis direction and/or a minor-axis direction of a laser-beam irradiated region at the time of application of said laser annealing or formed non-parallel with and non-orthogonal to the channel width direction of said first thin-film transistors
are used in said sampling transistors and the shift register.

10. The semiconductor device or the display device according to any one of claims 1 to 9 wherein
said laser annealing is performed to poly-crystallize an amorphous semiconductor layer or an amorphous semiconductor film and obtain a polycrystalline semiconductor layer or a polycrystalline semiconductor film.

11. The semiconductor device or the display device according to any one of claims 1 to 10 wherein
said channel width direction of the channel region of said semiconductor elements or said some or all of second thin-film transistors is set to a direction of about 45° relative to the side direction of said substrate, the major-axis direction and/or the minor-axis direction of the laser-beam irradiated region at the time of application of said laser annealing, or said channel width direction of said first thin-film transistors.
